# FASCICULE DE BREVET EUROPEEN

(11) **EP 1 397 529 B1**
(45) Date de publication et mention de la délivrance du brevet: **21.02.2007**
(21) Numéro de dépôt: 02738277.9
(22) Date de dépôt: 21.05.2002
(51) Int. Cl.: C23C 16/44, B01D 53/70, B01J 19/12, B01D 53/32

(54) **APPLICATION DES PLASMAS DENSES CREES A PRESSION ATMOSPHERIQUE AU TRAITEMENT D'EFFLUENTS GAZEUX**
VERWENDUNG VON UNTER ATMOSPHÄRISCHEM DRUCK ERZEUGTEN DICHTEN PLASMEN ZUR BEHANDLUNG VON ABGASEN
APPLICATION OF DENSE PLASMAS GENERATED AT ATMOSPHERIC PRESSURE FOR TREATING GAS EFFLUENTS

(30) Priorité: 31.05.2001 FR 0107150
(43) Date de publication de la demande: 17.03.2004
(73) Titulaire: L'Air Liquide Société Anonyme à Directoire et Conseil de Surveillance pour l'Etude et l'Exploitation des Procédés Georges Claude, 75321 Paris Cedex 07 (FR); Air Liquide Electronics Systems, 75007 Paris (FR)
(72) Inventeur: ROSTAING, Jean-Christophe, F-78000 Versailles (FR); GUERIN, Daniel, F-77500 Chelles (FR); LARQUET, Christian, F-78280 Guyancourt (FR); LY, Chun-Hao, F-75321 Paris Cedex 07 (FR); MOISAN, Michel, Outremont, Québec H2V 2Z1 (CA); DULPHY, Hervé, F-38000 Grenoble (FR)
(74) Mandataire: Vesin, Jacques
(86) Numéro de dépôt international: PCT/FR2002/001701
(87) Numéro de publication internationale: WO 2002/097158

(56) Documents cités:
- EP-A- 0 648 530
- WO-A-01/68224
- WO-A-01/91896
- US-A- 5 453 125
- US-A- 5 750 823
- US-A- 5 965 786
- US-A1- 2002 033 377
- US-B1- 6 187 072
- US-B1- 6 290 918

## Description

### Domaine technique et art antérieur

L'invention concerne le domaine du traitement de gaz par des techniques plasma, et notamment le traitement de gaz tels que des gaz perfluorés (PFC), en particulier per-fluorocarbonés, et/ou de gaz hydrofluorocarbonés (HFC), en vue de leur destruction.

Elle concerne une unité ou un dispositif de traitement de tels gaz, ainsi qu'un procédé de traitement de ces gaz.

Une industrie particulièrement concernée par ces problèmes est l'industrie des semi-conducteurs. En effet, la fabrication des semiconducteurs est l'une des activités industrielles utilisatrices de tonnages significatifs de gaz perfluorés (PFC) et hydrofluorocarbonés (HFC).

Ces gaz sont utilisés dans les procédés de gravure par plasma des motifs des circuits électroniques intégrés, et dans ceux de nettoyage par plasma, notamment des réacteurs d'élaboration de matériaux en couches minces par dépôt chimique en phase vapeur (CVD).

Ils sont aussi utilisés dans les procédés de production ou de croissance ou de gravure ou de nettoyage ou de traitement de semiconducteurs ou de dispositifs semiconducteurs ou de couches minces ou de couches minces semiconductrices ou conductrices ou diélectriques, ou de substrats, ou encore dans les procédés de retrait de résines photosensibles utilisées pour la lithographie des micro-circuits.

Pour cela, ces gaz PFC et/ou HFC sont dissociés au sein d'un plasma froid de décharge électrique, dans une chambre ou un réacteur, pour donner, notamment, du fluor atomique.

Ce dernier réagit avec les atomes de surface d'un matériau à traiter ou à attaquer pour donner des composés volatils qui sont extraits de la chambre par un système de pompage sous vide et dirigés vers l'échappement du système.

Les gaz perfluorés ou hydrofluorocarbonés ne sont pas en général complètement consommés par les procédés précités. Les quantités rejetées par les équipements peuvent dépasser 50% du débit de PFC ou de HFC entrant.

Les gaz perfluorés ou hydrofluorocarbonés sont notamment caractérisés par leur grande stabilité chimique et par leur absorption très élevée dans l'infrarouge. Ils sont donc soupçonnés de pouvoir contribuer significativement au réchauffement général du climat par renforcement de l'effet de serre.

Certains pays industrialisés se sont en principe engagés à réduire leur émission de gaz à effet de serre.

Certaines industries utilisatrices ont choisi d'anticiper l'évolution de la réglementation. En particulier, l'industrie des semiconducteurs occupe une position avancée dans l'adoption de politiques volontaristes de réduction des émissions.

Il existe plusieurs voies technologiques pour assurer ces réductions d'émissions.

Parmi les diverses solutions envisageables, l'optimisation des procédés actuels semble limitée dans ses possibilités. Le recours à des techniques de chimie alternative est inadapté à la plupart des équipements actuels. Quant à la technique de récupération et de recyclage des PFC ou HFC non convertis, elle s'avère très coûteuse, si l'on vise à fournir une purification des produits qui soit suffisante pour pouvoir les réutiliser dans le procédé.

Il existe aussi des techniques d'abattement ou de destruction des PFC ou HFC qui sont non convertis à la sortie des réacteurs.

On peut mentionner, parmi les techniques d'abattement connues, la conversion thermique des PFC dans un brûleur ou un four électrique, l'oxydation catalytique, ou les techniques plasma.

Ces techniques ont une efficacité limitée, notamment sur les molécules les plus stables telles que CF₄, ou bien ne permettent pas de traiter avec une efficacité satisfaisante les débits de PFC rencontrés dans la pratique dans les installations de fabrication de semi-conducteurs, et qui sont, pour les plus élevés, typiquement de l'ordre de quelques centaines de cm³ standard par minute.

Les documents EP 874 537, EP 847 794 et EP 820 201 décrivent des solutions d'abattement de gaz PFC ou HFC, mais aucun ne donne de mise en oeuvre pratique, en ligne, dans le cadre d'une unité de production de semiconducteurs. Certaines des solutions proposées (EP 820 801, EP 874 537) concernent exclusivement le cas de gaz porteurs de type gaz rares, pouvant être mises en oeuvre dans un laboratoire, mais pas sur une telle unité de production où l'utilisation de ces gaz rares comme gaz de dilution est exclue par les fabricants.

Aucune des autres solutions de type "plasma", connues actuellement pour traiter des effluents de procédés autres que les procédés de fabrication de semi-conducteurs, ne permet de traiter avec une efficacité satisfaisante des débits élevés de PFC tels que ceux rencontrés dans le domaine de la fabrication de semiconducteurs, typiquement de l'ordre de quelques centaines de cm³ standard par minute.

Les mêmes problèmes se posent pour toutes les activités mettant en oeuvre les techniques utilisées dans le domaine des semi-conducteurs, et notamment toutes les techniques mettant en oeuvre des gaz PFC et/ou HFC.

### Exposé de l'invention

L'invention concerne un système de traitement de gaz par plasma, selon la revendication 1.

Un tel système s'avère bien adapté au traitement de gaz de type PFC ou HFC mélangés à un gaz porteur à pression sensiblement égale à, ou de l'ordre de, la pression atmosphérique, en particulier dans le cas de PFC à des concentrations de l'ordre de 0,1 % à 1 % dans quelques dizaines de litres par minute d'azote ou d'air.

Le plasma est un plasma hors équilibre thermodynamique local, c'est-à-dire un plasma où une zone au moins de la décharge se situe hors équilibre thermodynamique local.

Un plasma entretenu à haute fréquence, dans la gamme du MHz ou du GHz supérieure à 50 MHz, ou de l'ordre de quelques centaines de MHz ou de quelques GHz, permet d'entretenir un tel plasma hors équilibre thermodynamique local.

Afin d'obtenir une bonne efficacité de conversion du plasma, on choisit des moyens pour produire un plasma, en sortie de pompe, produisant une densité électronique au moins égale à 10¹² cm⁻³ , par exemple comprise entre 10¹² et 10¹⁵ cm⁻³ ou préférablement entre 10¹³ et 10¹⁴ cm⁻³.

De préférence on limite la perte de charge en sortie de pompe, à moins de 300 mbar.

Or. l'utilisation d'un plasma à pression atmosphérique, en sortie de pompe, peut engendrer dans le tube, ou dans l'enceinte diélectrique généralement tubulaire à l'intérieur de laquelle est entretenue la décharge, des phénomènes de contraction radiale du plasma, nuisibles à un fonctionnement efficace du système de traitement selon l'invention.

Afin de conserver un degré de contraction modéré, selon un mode de réalisation, un tube à plasma de diamètre compris entre 8 mm et 4 mm, ou entre 8 mm et 6 mm, est sélectionné.

Afin de limiter les pertes de charge en sortie de pompe, on peut en outre sélectionner un tube plasma de longueur comprise entre 100 mm et 400 mm.

Les moyens pour produire un plasma comportent un tube à décharge plasma, le gaz à traiter traversant ce tube de haut en bas.

Ceci permet de limiter les risques de pollution ou de bouchage du tube par des dépôts liquides, pouvant conduire à une perturbation du couplage de la puissance micro-ondes au plasma ou à une perte de charge trop importante en sortie de pompe.

Des moyens de vidange peuvent alors être disposés en position basse du tube à plasma, afin de récupérer des condensats liquides et de les éliminer du circuit de traitement.

Selon encore un autre aspect, des moyens d'étuvage ou de piégeage peuvent être prévus sur le trajet des gaz, afin de limiter les dépôts solides ou les condensations pouvant accroître la perte de charge en sortie de pompe.

Le système de l'invention un dispositif réacteur comportant une chambre de réaction, produisant au moins un gaz PFC ou HFC, et comportant en outre un système de traitement de PFC ou de HFC tel que ci-dessus.

La chambre de réaction est par exemple un équipement de production ou de croissance ou de gravure ou de nettoyage ou de traitement de dispositifs semiconducteurs ou de couches minces ou de couches minces semiconductrices ou conductrices ou diélectriques ou de substrats, ou bien un réacteur de retrait de résines photosensibles utilisées pour la lithographie des micro-circuits, ou un réacteur de dépôt de couches minces en cours de nettoyage par plasma.

Le système de l'invention peut être utilisé avec un équipement de production ou de croissance ou de gravure ou de nettoyage ou de traitement de semiconducteurs ou de dispositifs semiconducteurs ou de couches minces ou de substrats de semi-conducteurs, comportant:
- un réacteur, de production ou de croissance ou de gravure ou de nettoyage ou de traitement de semiconducteurs ou de dispositifs semiconducteurs ou de couches minces ou de couches minces semiconductrices ou conductrices ou diélectriques ou de substrats, ou bien un réacteur de retrait de résines photosensibles utilisées pour la lithographie des micro-circuits, ou un réacteur de dépôt de couches minces en cours de nettoyage par plasma,
- des premiers moyens de pompage de l'atmosphère du réacteur,
- un système de traitement tel que décrit ci-dessus.

Le système de traitement est de préférence situé à proximité du réacteur. Il peut avantageusement être situé dans un étage de facilités de l'unité de traitement ou de production ou de gravure ou de nettoyage, ou encore dans un plancher d'un atelier de fabrication ou de traitement ou de production ou de gravure ou de nettoyage.

L'invention concerne également un procédé de traitement de gaz par plasma selon la revendication 11.

Le gaz à traiter peut être préalablement mélangé à un gaz vecteur à pression sensiblement atmosphérique, par exemple de l'azote ou de l'air, injectés à l'aide de moyens d'injection d'azote ou d'air.

L'azote ou l'air a un effet diluant (cas de produits de réaction dangereux) et un rôle plasmagène.

Avantageusement, le traitement par plasma a lieu dans un tube à décharge, le procédé comportant une étape préalable d'adaptation du diamètre de ce tube de manière à limiter les phénomènes de contraction radiale de la décharge dans ce tube.

Le procédé peut être appliqué à une réaction chimique dans un réacteur, ladite réaction produisant ou émettant au moins un gaz résiduel à traiter par le procédé de traitement.

Ladite réaction peut être par exemple une réaction de production ou de croissance ou de gravure ou de nettoyage ou de traitement de semiconducteurs ou de dispositifs semiconducteurs ou de couches minces ou de couches minces semiconductrices ou conductrices ou diélectriques ou de substrats, ou bien une réaction de retrait de résines photosensibles utilisées pour la lithographie des micro-circuits, ou une réaction de dépôt de couches minces en cours de nettoyage par plasma, à l'aide de gaz PFC et/ou HFC, les gaz résiduels étant notamment des gaz PFC et/ou HFC.

### Brève description des figures

Les caractéristiques et avantages de l'invention apparaîtront mieux à la lumière de la description qui va suivre. Cette description porte sur les exemples de réalisation, donnés à titre explicatif et non limitatif, en se référant aux dessins annexés sur lesquels :
- la figure 1 représente un schéma d'un équipement de production de semi-conducteurs, selon l'invention,
- la figure 2 représente un schéma d'une source plasma,
- les figures 3 et 4 représentent schématiquement des installations de production de semi-conducteurs

### Description détaillée de modes de réalisation de l'invention

L'invention va d'abord être décrite dans le cadre d'une installation de production de semi-conducteurs.

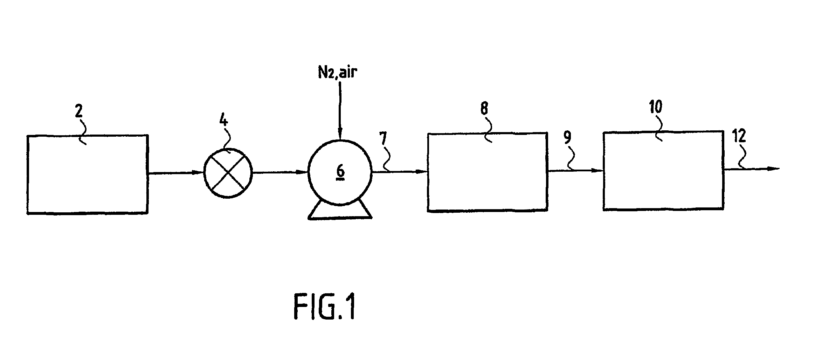

Une telle installation, munie d'un système de traitement selon l'invention comporte, comme illustré sur la figure 1, un réacteur de production, ou machine de gravure 2, un système de pompage comportant une pompe secondaire 4, telle qu'une pompe turbomoléculaire 4, et une pompe primaire 6, des moyens 8 d'abattement de composés PFC et/ou HFC, du type générateur de plasma.

En fonctionnement, la pompe 4 maintient le vide nécessaire dans l'enceinte de procédé et assure l'extraction des gaz rejetés.

Le réacteur 2 est alimenté en gaz de traitement des produits semiconducteurs, et notamment en PFC et/ou en HFC. Des moyens d'alimentation en gaz alimentent donc le réacteur 2 mais ne sont pas représentés sur la figure.

Typiquement ces gaz sont introduits dans le réacteur avec un débit de l'ordre de la, ou de quelques, dizaine(s) à quelques centaines de sccm (centimètres cubes standard par minute), par exemple compris entre 10 et 200 ou 300 sccm.

Ces gaz ne sont en général pas consommés entièrement par le procédé de traitement ou de fabrication de semi-conducteurs, et ceci jusque dans des proportions pouvant être supérieures à 50%. Il est donc tout à fait commun d'avoir des débits de PFC et/ou HFC, en sortie de pompe primaire 6, de l'ordre de quelques dizaines à quelques centaines de sccm, par exemple compris entre 10 sccm et 100 ou 200 sccm.

Les moyens 8 permettent de réaliser un traitement (dissociation ou transformation irréversible) de ces composés PFC et/ou HFC non utilisés, mais peuvent également produire, par là-même, des sous-produits, tels que F₂ et/ou HF et/ou SiF₄ et/ou WF₆ et/ou COF₂ et/ou SOF₂ et/ou SO₂F₂ et/ou NO₂ et/ou NOF et/ou SO₂.

Ces moyens 8 sont des moyens pour dissocier les molécules des gaz entrant dans les moyens 8, et pour former des composés réactifs, notamment fluorés.

Plus précisément, le plasma des moyens 8 permet d'ioniser les molécules du gaz soumis au plasma, par arrachement d'électrons des molécules de gaz, initialement neutres.

Sous l'action de la décharge, les molécules du gaz à traiter ou à purifier, et notamment les molécules du gaz de fond, sont dissociées pour former des radicaux de taille plus petite que les molécules initiales et, par suite, le cas échéant, des atomes individuels, les atomes et fragments de molécules du gaz de fond ainsi excités ne donnant lieu à sensiblement aucune réaction chimique.

Après passage dans la décharge, les atomes ou molécules de gaz de fond se désexcitent et se recombinent respectivement, pour se retrouver intacts en sortie.

Au contraire, les impuretés subissent par exemple une dissociation et/ou une transformation irréversible par formation de nouveaux fragments moléculaires ayant des propriétés chimiques différentes de celles des molécules initiales, qui sont dès lors susceptibles d'être extraites du gaz par un traitement ultérieur approprié.

Un élément réactif 10 permet de faire réagir les composés résultant du traitement par les moyens 8 avec un élément réactif correspondant (par exemple: un adsorbant réactif solide) en vue de leur destruction. Les gaz résultant du traitement par les moyens 10 (en fait: le gaz vecteur chargé de composés de type PFC et/ou HFC et/ou d'autres impuretés telles que celles mentionnés ci-dessus) sont ensuite rejetés dans l'air ambiant, mais sans danger, avec des proportions de PFC et/ou de HFC compatibles avec le respect de l'environnement (typiquement: moins de 1% de la concentration initiale) et des proportions très faibles et autorisées d'impuretés nocives, c'est-à-dire inférieures aux limites d'exposition légales, typiquement moins de 0,5 ppm ou moins de 1 ppm.

Pour des raisons de sécurité, les effluents gazeux provenant du réacteur ou de la chambre de production 2 sont, en aval ou au niveau de l'échappement de la pompe primaire ou du groupe de pompage primaire, fortement dilués dans de l'azote (avec un gaz adjuvant : l'oxygène) ou de l'air à pression sensiblement atmosphérique. Le système comporte donc des moyens d'injection de gaz d'azote (et d'oxygène) ou d'air, non représentés sur la figure 1. L'air, ou l'azote (et l'oxygène), est injecté au niveau de l'étage haute-pression de la pompe primaire.

De préférence, on injecte de l'azote sec, obtenu par distillation cryogénique, comme gaz de dilution. On réduit ainsi les problèmes (expliqués plus loin) liés à la présence éventuelle d'humidité résiduelle, à l'origine de la formation de produits non gazeux (H₂SO₄ ou HNO₃ ou SiOₓN_{y}, ou, dans le cas d'une gravure de tungstène, WOₓ ou WOF₄) ou d'autres problèmes tels que l'hydrolyse de SiF₄ ou de WF₆, ce qui conduit à des dépôts dès avant le plasma de dépollution.

Le débit de fluide en sortie de pompe primaire 6 est imposé par cette dilution, les débits typiques rencontrés étant de l'ordre de quelques dizaines de litres par minute (par exemple : entre 10 et 50 l/mn) d'azote ou d'air, dans lequel sont contenus 0, 1 % à 1% de PFC et/ou de HFC.

La pression, en sortie de pompe, est de l'ordre de la pression atmosphérique, par exemple comprise entre 0,7 bar ou 0,8 bar et 1,2 bar ou 1,3 bar.

L'utilisation, à pression atmosphérique, d'un gaz vecteur tel que l'air ou l'azote requiert une énergie importante pour ioniser le gaz par les moyens de production plasma 8 et pour entretenir le plasma (au moins 150 W/centimètre de tube à décharge, par exemple environ 200 W/centimètre de tube à décharge ; selon un autre exemple, une puissance comprise entre 150 et 500 W/cm de tube peut être sélectionnée.

Le plasma produit par les moyens 8 est hors équilibre thermodynamique local (ETL). Ce peut aussi être un plasma pour lequel au moins une zone de la décharge se trouve hors équilibre thermodynamique local. Il est ainsi possible d'utiliser une torche micro-ondes, classée généralement dans les plasmas thermiques, mais dont la zone de « panache », qui forme une fraction appréciable du volume de la décharge, et où peuvent se produire une grande part des réactions de conversion, est sensiblement hors ETL.

La décharge ou la source plasma est du type entretenu par un champ HF, dans le domaine du MHz et du GHz. A ces fréquences élevées, les électrons répondent majoritairement, ou exclusivement, au champ excitateur, d'où le caractère hors ETL de ces décharges. Le contrôle de l'écart à l'équilibre thermodynamique peut permettre d'optimiser une chimie de transformation en maîtrisant la nature des sous-produits. Différents paramètres opérationnels externes ont de l'influence sur cet écart, par exemple le choix du gaz de dilution ou l'addition en faible quantité de certains gaz adjuvants, ou la fréquence de l'excitation. Cette dernière a aussi un effet sur la densité électronique du plasma qui, d'une manière générale, croît avec elle. Des plasmas entretenus par des champs micro-ondes à pression atmosphérique présentent des densités élevées (10¹² à 10¹⁵ cm⁻³ à 2,45 GHz, et plus précisément de 10¹³ à 10¹⁴ cm⁻³ dans l'azote ou l'air), qui contribuent à atteindre une bonne efficacité de conversion des PFC et/ou des HFC, y compris dans l'azote ou l'air.

En pratique, on choisira, pour la fréquence, l'une des bandes centrées à 433,92 MHz, 915,00 MHz, 2,45 GHz et 5,80 GHz. La bande immédiatement inférieure à 40,68 MHz est déjà dans la gamme radiofréquence, où les densités de plasma seront trop faibles pour obtenir une bonne efficacité.

Il existe plusieurs familles génériques de sources de plasma haute fréquence pouvant fonctionner à pression atmosphérique, conduisant à des gammes de caractéristiques différentes pour les décharges, et présentant divers avantages ou inconvénients, notamment quant à leur simplicité de conception et de fabrication, à leur facilité de mise en oeuvre pour le problème posé, à leur coût.

Dans le cadre de l'application envisagée, les quatré types de sources suivants peuvent être utilisées.

Il s'agit d'abord des plasmas entretenus à l'intérieur de cavités résonnantes. Une cavité peut être alimentée, indifféremment par un guide d'ondes ou par une ligne coaxiale. L'extension spatiale de la décharge est limitée par la taille de la cavité. La densité électronique du plasma ne peut excéder, de manière large, la densité critique à la fréquence considérée, à la différence, notamment, des sources de plasma à onde de surface.

Sont également concernés les plasmas entretenus à l'intérieur d'un guide d'onde, que l'on peut en fait assimiler à des cavités imparfaites. Ces plasma sont également soumis aux deux limitations précédemment évoquées, sur la taille et la densité électronique. En outre, l'extension maximale de la décharge correspond à une des dimensions de la section du guide.

Les torches représentent un troisième type de source de plasma de haute fréquence utilisables dans le cadre de la présente application. La décharge forme une charge absorbante à l'extrémité d'un tronçon de ligne de transmission (généralement coaxiale) de la puissance HF. Une torche peut être alimentée en puissance par une ligne coaxiale ou par un guide d'onde. Une augmentation de la puissance se traduit à la fois par une augmentation de la densité et du volume de la flamme et du panache.

Le quatrième type de source de plasma haute fréquence pouvant opérer à pression atmosphérique est constitué par la famille des applicateurs à onde de surface. Dans le cas d'une source de plasma à onde de surface, l'extension de la colonne de plasma peut être accrue en augmentant simplement la puissance micro-ondes incidente, sans qu'il soit besoin de redimensionner l'applicateur de champ. La densité du plasma dans la colonne dépasse la densité critique.

Des informations plus précises sur ces différents types de sources sont données dans les chapitres 4 et 5 de Microwave Excited Plasmas, eds. M. Moisan and J. Pelletier, Elsevier, Amsterdam, 1992.

Pour des débits de l'ordre de quelques dizaines de litres par minute de gaz vecteur azote ou air (avec des PFC et/ou HFC à une concentration comprise entre 0,1% et 1% ou quelques %), il est tout à fait possible d'atteindre, avec une source plasma HF à pression atmosphérique, des taux de conversion supérieurs à 95%.

Quelle que soit la source plasma utilisée (à l'exception des torches), celle-ci met en oeuvre une enceinte généralement tubulaire à l'intérieur de laquelle est entretenue la décharge ou un tube diélectrique dans lequel la décharge est réalisée. Il peut s'agir par exemple d'un tube du type décrit dans le document EP 1 014 761. Un tube ou une enceinte tubulaire de longueur comprise entre 100 et 400 mm, par exemple de l'ordre de 300 mm, et de diamètre interne compris entre 4 et 8 mm, permet de ne pas introduire de pertes de charges trop importantes en sortie de pompe, c'est-à-dire qui ne seraient pas compatibles avec la pompe primaire 6. En effet, celle-ci ne peut en général fonctionner qu'avec, en sortie, une perte de charge au plus égale à 300 mbar, une perte de charge trop forte, de l'ordre de 400 mbar, entraînant en général l'arrêt de la pompe primaire; ce qui, dans une application à une chaîne de production de semiconducteurs, est difficilement acceptable.

Malgré la sélection d'une longueur de tube appropriée, un autre problème est celui de la formation de dépôts solides et/ou liquides dans le circuit de gaz situé en aval de la pompe primaire. De tels dépôts peuvent se produire et occasionner à leur tour des pertes de charge et/ou de la corrosion pouvant nuire de manière substantielle au fonctionnement de l'unité de production et conduire à son arrêt. C'est par exemple le cas dans les zones où un refroidissement est réalisé, notamment en sortie de plasma.

Par ailleurs, dans les décharges HF à pression atmosphérique, et dans la gamme de débits habituellement imposés par la pompe 6 (quelques dizaines de litres de gaz vecteur par minute), un phénomène de contraction radiale peut apparaître : la densité électronique décroît de l'axe vers la périphérie du tube, et les molécules du gaz circulant à la périphérie rencontrent moins d'espèces actives sur leur parcours que celles passant près de l'axe du tube. Dans certains cas, la décharge peut ne plus remplir toute la section et on assiste alors à l'apparition de plusieurs filaments de plasma se déplaçant de manière erratique, de sorte que le rendement de conversion chute rapidement.

Le degré de contraction dépend de plusieurs facteurs, notamment : le diamètre du tube, la nature du gaz de dilution, les impuretés et gaz adjuvants, la vélocité du flux, la conductivité thermique de la paroi du tube, la fréquence d'excitation. D'une manière générale, toutes choses égales par ailleurs, le degré de contraction diminue lorsqu'on réduit le diamètre interne de l'enceinte à décharge, ou que l'on diminue la fréquence. Toutefois, le diamètre du tube ne peut être réduit arbitrairement, car, d'une part, on augmente corrélativement la sollicitation thermique de la paroi, et, d'autre part, la perte de charge à travers le réacteur 8 de dépollution par plasma peut devenir prohibitive en fonction du débit total (cas du branchement de plusieurs pompes primaires par exemple).

Or une perte de charge excessive résulte, comme on l'a déjà expliqué ci-dessus, en un arrêt de la pompe primaire 6 et de toute l'unité de production.

Le diamètre interne du tube peut être sélectionné entre 8 mm et 4 mm pour réduire la contraction et obtenir un taux de conversion important, tout en n'imposant pas une perte de charge excessive à la pompe primaire 6. En se plaçant dans les conditions les plus favorables, on diminue la longueur de la décharge permettant d'obtenir un taux de conversion donné.

Il est donc préférable, préalablement à la mise en oeuvre de l'installation, de sélectionner le diamètre interne du tube de sorte que le phénomène de contraction soit moins important. L'utilisation de tubes de diamètres variables permet de faire varier l'efficacité du procédé.

Une autre manière d'augmenter la longueur du parcours des molécules de PFC dans la décharge est d'agir sur la circulation du flux gazeux, par exemple un générant un vortex de façon à rendre curviligne plutôt que linéaire la trajectoire des particules.

Le tube aura de préférence une épaisseur de l'ordre de 1 mm ou comprise entre 1 et 1,5 mm.

Le tube est donc mince. En fonctionnement, la température de sa face externe en est d'autant plus élevée. Toutefois il a été constaté (essais avec plusieurs centaines d'heures de fonctionnement) que cela ne met pas en cause la stabilité thermique du fluide de refroidissement : ce fluide ne subit aucune dégradation appréciable, même sur une très longue durée.

En outre, un tube d'épaisseur voisine de 1 mm permet d'effectuer des mesures optiques pour contrôler le bon fonctionnement de la source plasma, et notamment pour contrôler la longueur de la colonne. Un plasma dans l'air ou l'azote peut être optiquement contrôlé à travers un tube d'épaisseur 1 mm, ou comprise entre 1 mm et 1,5 mm, ce qui est beaucoup plus difficile à travers un tube de 2 mm d'épaisseur.

Suivant le type de source choisi, ces principes généraux pourront être appliqués de différentes manières et contribuer plus ou moins à l'optimisation de l'efficacité de conversion.

Dans une cavité résonnante, la densité de plasma ne peut dépasser de beaucoup la densité critique, du moins si l'on s'en tient à des modes de cavité vrais. En effet, si l'on augmente la puissance, on peut faire apparaître des modes d'onde de surface, stationnaires si la cavité demeure fermée par des fonds conducteurs à ses extrémités, progressifs dans le cas contraire. Dans le cas d'un mode de surface, la densité est toujours supérieure à la densité critique. Pour une cavité fermée, l'extension de la décharge le long du tube est limitée par la taille de la cavité. La longueur de celle-ci est donc choisie par construction de manière à offrir un volume suffisant de plasma pour obtenir le rendement de conversion désiré.

Le même type de considérations s'applique à une décharge en guide d'ondes. Dans ce cas, une dimension de la section du guide impose la longueur maximale de la décharge, à moins que, pour une puissance suffisante et selon la configuration du guide, l'onde se propage à l'extérieur de ce dernier qui devient alors un applicateur à onde de surface. Les dimensions du guide satisferont en outre aux conditions d'existence du mode de propagation guidée à la fréquence considérée.

Le cas d'une torche est sensiblement différent, le dard et le panache de la flamme plasma débouchant dans une enceinte dont les dimensions sont généralement assez grandes par rapport à celles de la buse, de manière à ne pas perturber la régularité de l'écoulement et la symétrie de la flamme. Cette enceinte permet de collecter le flux de gaz chargé en sous-produits pour le diriger vers les moyens de post-traitement situés en aval. Les détails de la forme de la buse jouent un rôle dans le contrôle du parcours des espèces dans la flamme (nombre et dimension des orifices, positionnement dans la section). Il peut être également indiqué d'optimiser l'écoulement dans l'enceinte dans le même but.

Enfin, dans le cas d'un plasma d'onde de surface, l'extension de la décharge n'est pas limitée par la taille de la structure conductrice de l'applicateur de champ, qui de ce fait n'a pas besoin d'être adaptée en fonction des performances désirées. La longueur de la décharge dans le tube peut être augmentée à la valeur désirée en accroissant la puissance HF incidente délivrée par le générateur.

Le circuit de gaz de l'ensemble des moyens de traitement du système de la figure 1 comprend, en partant de la pompe primaire 6, la canalisation 7 amenant les effluents au module réactif à plasma 8, puis celle (9) reliant le plasma au dispositif 10 de post-traitement des sous-produits, enfin la canalisation 12 d'échappement à l'atmosphère des gaz détoxifiés pouvant être rejetés sans danger. S'y ajoutent différents composants de gestion des fluides (vannes de dérivation, utilités de purge et d'isolation pour la maintenance) et des capteurs de sécurité (alarmes sur défaut de débit, surpression), non représentés sur la figure 1. Les composants du circuit sont choisis compatibles avec les produits qui sont à leur contact pour un fonctionnement fiable.

Des systèmes d'étuvage ou de piégeage peuvent en outre être présents.

En effet, les effluents extraits de la pompe primaire 6, revenus à pression atmosphérique, ne restent pas tous nécessairement sous forme gazeuse. Les problèmes sont généralement aggravés par la présence éventuelle d'humidité résiduelle (quelques centaines de ppmv) dans le gaz de dilution. Par exemple, un procédé de gravure par SF₆ peut donner du souffre solide, H₂SO₄ et HNO₃, etc... Certains effluents peuvent se condenser ou se déposer sous forme solide, créant ainsi un risque d'augmentation de la perte de charge en sortie de la pompe 6. Il en résulte un risque, déjà indiqué ci-dessus, d'arrêt de la pompe primaire 6 et, avec elle, de toute l'unité de production.

Par ailleurs, le diamètre de l'enceinte tubulaire à plasma, compte tenu du phénomène de contraction radiale déjà évoqué ci-dessus, ne dépasse pas en général une dizaine de mm. Pour un débit total de l'ordre de quelques dizaines de slm (imposé par la pompe primaire 6), la vitesse du flux de gaz est telle que les échanges thermiques (diffusion radiale de la chaleur) sont trop lents pour que la majorité de l'énergie thermique générée dans le plasma soit emportée par le fluide de refroidissement de l'enceinte. Du fait que les puissances micro-ondes nécessaires pour entretenir un plasma suffisamment dense dans l'azote ou l'air sont très importantes, une enthalpie considérable se trouve transportée en aval de l'enceinte à décharge. Dans cette zone, le gaz est refroidi rapidement par des moyens de refroidissement, par exemple au moyen d'une structure d'échangeur thermique à eau, pour éviter une destruction de la canalisation. Ce faisant, on crée ainsi une zone préférentielle pour la condensation de résidus, la corrosion et/ou le bouchage de ladite canalisation d'où, encore, un risque d'augmentation de la perte de charge en sortie de la pompe 6.

Dans ces conditions, selon un mode de réalisation de l'invention, on évite, contrairement à toutes les installations plasma existantes actuelles, de faire fonctionner un réacteur 8 de dépollution en flux montant avec l'échangeur à sa partie supérieure.

En outre, dans le cas d'un flux montant, des résidus solides et liquides peuvent retourner dans l'enceinte à plasma par simple gravité et altérer son fonctionnement. On a observé, par exemple dans le cas de la gravure au SF₆, que l'acide sulfurique, liquide visqueux à faible tension de vapeur, mouillant la paroi interne du tube, interdit tout ré-allumage du plasma du fait de ses mauvaises propriétés diélectriques. Il faut alors procéder à un rinçage et à un séchage du tube, d'autant plus malaisé dans cette géométrie.

Il est donc préférable, pour ces raisons, d'inverser le sens de circulation du flux gazeux et de le faire circuler de haut en bas. Eventuellement, des moyens de vidange peuvent être prévus en position basse du tube, par exemple une structure d'échangeur collecteur, pour permettre la vidange au point bas des résidus liquides.

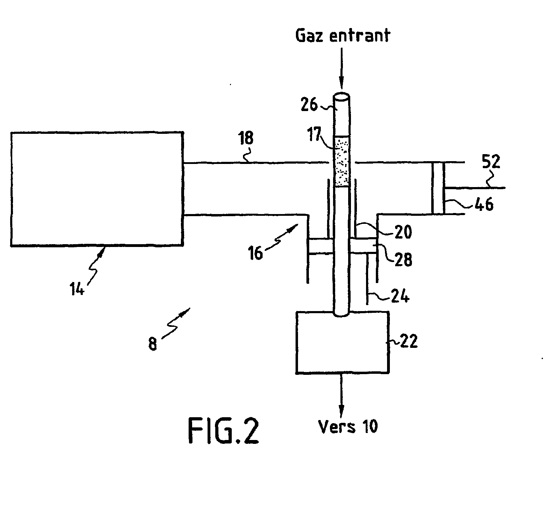

La figure 2 représente des moyens de traitement 8 selon l'invention, comportant un générateur micro-ondes 14, un guide d'ondes 18, et un tube à décharges 26. Ce dernier est disposé dans un manchon 20, en matériau conducteur et tel que décrit par exemple dans le document EP - 820 801.

Ce surfatron-guide est en outre muni de moyens 24, 52 de réglage de la position axiale du piston en guide d'onde 46 et du piston d'accord 48 coaxial au tube à décharge. Ce second piston forme piège en quart d'onde. Il est fixé sur une rondelle 50 de coulissement, par exemple en téflon. Les moyens 24, 52 sont en fait des tiges actionnables manuellement en vue de l'ajustement en impédance du système.

Sur la figure 2, le gaz est représenté circulant de haut en bas, conformément à ce qui a été exposé ci-dessus. La référence 22 désigne en outre des moyens de vidange en position basse du tube 16, pour permettre la vidange au point bas des résidus liquides.

La longueur des canalisations peut influer sur la nature des produits qui vont effectivement se présenter au système 10 de post-traitement. Il peut être indiqué, dans le cas d'un système 10 à adsorbant réactif solide, de localiser ce dernier aussi près que possible de la sortie du plasma, afin qu'il n'ait à traiter que des produits gazeux, pour lequel il est spécifiquement conçu.

Les spécifications du système 10 de post-traitement sont de préférence choisies pour tenir compte de la génération de sous-produits (gaz fluorés corrosifs comme HF, F₂, COF₂, SOF₂..., oxydes d'azote...) par le procédé et le plasma de conversion des PFC. L'exploitation de l'écart à l'équilibre thermodynamique ne donne pas une souplesse absolue pour contrôler les concentrations respectives de ces sous-produits.

En outre certaines caractéristiques du dispositif 10 de post-traitement peuvent être imposées a priori par exemple du fait d'installations déjà existantes, ou de méthodes de dépollution établies chez l'utilisateur.

En général des moyens de refroidissement (non représentés sur la figure 1) sont prévus pour la source de plasma (notamment pour l'enceinte à décharge et la sortie des gaz) et les alimentations en énergie électromagnétique. Outre les puissances thermiques à évacuer, certaines gammes de températures peuvent être imposées, par exemple pour éviter la condensation à l'arrêt. L'architecture des circuits de refroidissement est alors de préférence adaptée de manière à pouvoir utiliser comme sources de frigories les réseaux d'eau froide standard de l'usine.

La puissance HF incidente est un paramètre opérationnel du circuit d'énergie électromagnétique et de la source de plasma. Afin que la source fonctionne dans de bonnes conditions de rendement énergétique (transmission effective de la puissance au plasma), on cherche à minimiser la puissance réfléchie vers le générateur ainsi que les pertes par échauffement dans la structure d'applicateur de champ.

Selon la conception de la source de plasma, on pourra utiliser des moyens d'ajustement externes comme des pistons de court-circuits 46 (figure 2) mobiles en bout de guide ou des vis d'accord, afin d'assurer un bon accord d'impédance.

L'accord d'impédance peut être plus ou moins insensible aux conditions de fonctionnement (marche-arrêt de l'équipement, procédé multi-étapes, dérives et fluctuations). Les systèmes basés sur des cavités sont par exemple plus « pointus » que ceux à onde de surface et il peut être indiqué de prévoir des moyens automatiques d'accord asservis sur la mesure de puissance réfléchie. Cette dernière est également, d'une manière générale, un paramètre caractérisant le bon fonctionnement de la source de plasma, les défaillances étant en général associées à une augmentation sensible de la puissance réfléchie.

Cela n'est toutefois pas systématique et d'autres paramètres physiques peuvent permettre d'assurer une bonne sûreté de fonctionnement, comme certaines signatures caractéristiques du plasma (extension, luminosité...), que l'on diagnostique par des capteurs optiques, ou des variations thermiques anormales au niveau de la source de plasma. Cette dernière est en outre munie de moyens de démarrage appropriés. En effet, un plasma d'azote ou d'air peut ne pas s'initier spontanément à pression atmosphérique lorsqu'on établit la puissance HF.

Il peut exister, pratiquement, des contraintes liées à l'intégration et à l'exploitation dans une unité de fabrication des semiconducteurs. Mais, d'une manière générale, la structure proposée selon l'invention peut s'adapter aux modes de fonctionnement des machines de procédé de ce domaine et aux pratiques générales du fabricant de semi-conducteurs, par exemple dans le cas d'une exploitation intermittente uniquement pendant les phases de procédé, avec des procédures de marche-arrêt appropriées et un interfaçage des automatismes à la pompe et à l'équipement de dépôt/gravure.

Elle est également compatible avec un faible encombrement, souvent imposé par les structures des unités de production de semi-conducteurs, du fait de la rareté et du coût de l'espace dans l'étage des facilités des usines de fabrication des semiconducteurs.

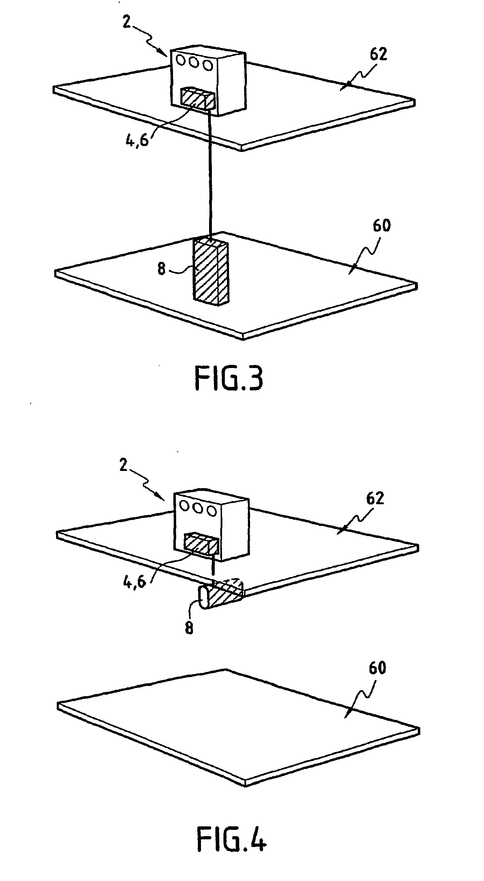

Comme illustré sur les figures 3 et 4, différents schémas d'implantation peuvent être choisis.

L'unité de traitement 8 peut être située à quelques mètres (par exemple: moins de 5 m) de la machine ou du réacteur 2 ou de la pompe primaire 6, dans l'étage 60 des facilités de l'unité de production, comme sur la figure 3. Le réacteur 2 est, lui, situé, dans l'atelier de fabrication 62.

Dans le cas de la figure 4, elle peut être plus fortement compactée et intégrée, avec la pompe à vide 6 et au plus près de l'équipement 2, dans le plancher de l'atelier 62 de fabrication.

Un exemple particulier de réalisation va maintenant être donné. Il concerne un système à onde de surface pour réacteur de gravure SF₆/C₄F₈ :

### 1. Circuit micro-ondes et applicateur de champ.

La fréquence d'excitation choisie est de 2,45 GHz. L'acheminement de puissances micro-ondes suffisantes pour l'application (plusieurs kW) est possible, à cette fréquence, à l'aide d'un guide d'ondes, généralement au standard WR 340, présentant une section de taille raisonnable. Les applicateurs de champ peuvent être de type surfatron-guide ou surfaguide, ce dernier offrant une plus grande simplicité. Le surfaguide permet un excellent accord d'impédance uniquement en ajustant la position du piston de court-circuit mobile fermant le guide d'ondes à son extrémité, sans avoir recours à un adaptateur à 3 vis.

Le circuit micro-ondes comprend donc:
- un générateur hyperfréquence (alimentation à découpage et tête magnétron) à puissance réglable jusqu'à une valeur maximale de 6 kW,
- un circulateur avec charge d'eau adaptée pour dissiper la totalité de la puissance réfléchie afin qu'elle ne revienne pas au magnétron,
- des moyens de mesure de la puissance incidente et de la puissance réfléchie,
- l'applicateur de champ surfaguide constituant, avec le tube diélectrique à décharge, la source de plasma,
- enfin, un piston de court-circuit mobile, manuel ou motorisé, en bout de guide, pour l'accord d'impédance.

### 2. Circuit de gaz.

Il est réalisé pour l'essentiel en matériau résistant aux produits corrosifs fluorés, c'est-à-dire en polymère de type PVDF ou PFA, sauf pour les parties actives de la source 8 de plasma et les composants qui sont le siège d'une forte génération de chaleur, comme l'élément de canalisation aval immédiatement contigu au tube à décharge, qui restent en matériaux métalliques ou céramiques.

A l'échappement de la pompe à vide primaire 6, un système de vannes de dérivation (une vanne trois voies ou trois vannes deux voies, selon la disponibilité commerciale de composants appropriés) permet l'évitement du système de traitement par le flux gazeux en cas d'incident de fonctionnement ou pendant les phases de maintenance. Ces vannes sont interfacées mécaniquement ou électriquement de manière à éviter toute fermeture intempestive de l'échappement qui provoquerait une montée en pression et l'arrêt de la pompe. L'unité de dépollution plasma 8 comporte elle-même des moyens de détection des excès de pertes de charge sur le flux de gaz à traiter.

Le tube à décharge est à double paroi, le refroidissement étant assuré par la circulation entre ces deux parois d'un fluide diélectrique grâce à une pompe hydraulique à engrenage. Ce fluide est à son tour refroidi en continu par échange thermique avec l'eau froide fournie en réseau au niveau des facilités de l'unité de fabrication de semiconducteurs. Le tube central, au contact du plasma, est réalisé en matériau céramique approprié, bon diélectrique, réfractaire et résistant aux sollicitations thermiques, résistant également à l'attaque chimique par les espèces fluorées corrosives.

A la sortie du tube à décharge, le gaz peut se trouver à une température élevée car le plasma micro-ondes à pression atmosphérique, bien qu'étant en général hors d'équilibre thermique, n'est pas un plasma dit « froid » analogue aux décharges à basse pression. Le gaz est donc refroidi avant d'être dirigé vers la canalisation aval, grâce à un échangeur thermique à eau. Ce refroidissement peut provoquer ponctuellement la condensation de produits liquides ou solides qu'il est souhaitable de pouvoir collecter commodément pour ne pas risquer un bouchage de l'installation. Pour cette raison, on utilise, comme déjà expliqué plus haut, un fonctionnement en flux descendant, avec l'échangeur disposé en position inférieure. Un piquage approprié permet le cas échéant de vider le collecteur à intervalles réguliers.

Le dispositif 10 de neutralisation des gaz fluorés corrosifs est implanté de préférence à faible distance en aval du plasma. Il s'agit d'une cartouche à adsorbant réactif solide, préférablement conçue pour fixer du fluor moléculaire qui sera le principal sous-produit dans la mesure où le procédé de gravure ou de nettoyage n'utilise pas d'eau ou d'hydrogène. Le lit retient également, en quantité moindre, les produits de gravures comme SiF₄ ou WF₆, et d'autres produits de dissociation dans le plasma de procédé ou celui de dépollution, comme COF₂, SOF₂,...

Le circuit de gaz comporte un ensemble de vannes manuelles ou motorisées, permettant d'isoler, purger et balayer avec un gaz neutre les différentes parties du montage.

### 3. Circuit de fluides de refroidissement.

L'eau fournie au niveau des facilités de l'usine de fabrication de semiconducteurs est utilisée pour refroidir l'alimentation à découpage et la tête magnétron du générateur, le fluide diélectrique de refroidissement du tube à décharge, et le gaz à la sortie du tube à plasma. Pour retirer les calories du fluide diélectrique, on utilise l'eau du réseau froid proprement dit, en circuit fermé (environ 5 °C) dans un échangeur à plaque. En revanche, pour le générateur, il n'est pas souhaitable de risquer des phénomènes de condensation pouvant générer des courts-circuits. On préférera donc l'eau dite « de ville » à 20°C environ, qui circulera successivement dans l'alimentation à découpage et la tête magnétron, puis dans l'échangeur-collecteur en post-décharge. En pratique cette eau « de ville » viendra également d'un circuit fermé et sa température est de préférence régulée de façon centralisée si le nombre de machines installées est important.

### 4. Exemple de procédé et performances.

Un système de dépollution par plasma, selon l'invention, est implanté, conformément au schéma de la figure 1, en aval d'une machine 2 de gravure plasma ALCATEL 601 E. La chimie de gravure du silicium monocristallin utilise en séquence les gaz SF₆ et C₄F₈ (14"-3" par exemple) à des débits respectifs de 170 sccm et 75 sccm.

En pratique, après passage à travers les pompes à vide 4, 6 et la canalisation de sortie, les gaz se présentent en concentration moyennée dans le temps à l'entrée de l'unité 8 de dépollution plasma. Avec les concentrations indiquées ci-dessus, le SF₆ se présente en entrée de l'unité 8, à une concentration de 90 sccm, accompagné de C₄F₈ à une concentration de 24 sccm.

Le système 10 de neutralisation des gaz acides fluorés est une cartouche de marque CleanSorb^{™} du commerce. Le courant d'effluents gazeux est analysé en différents points de l'installation par spectrométrie de masse quadrupolaire.

Le procédé de gravure ALCATEL utilise les gaz PFC SF₆ et C₄F₈. La dilution à l'échappement de la pompe primaire 6 s'effectue à l'air sec (environ 100-150 ppm H₂O résiduel) à raison de 30 slm. A la sortie de la chambre 2 de gravure (source ICP haute densité) on mesure les concentrations de SF₆ et de C₄F₈. Les taux de destruction dans le plasma de dépollution sont calculés comme le rapport de la concentration en sortie sur la concentration en entrée dudit plasma, i.e. sans intégrer la dissociation préalable par le procédé de gravure lui-même.

A la sortie du plasma de dépollution 8, on trouve, outre les concentrations résiduelles des deux PFC, les sous-produits suivants : SiF₄, F₂, COF₂, SOF₂, NO₂, SO₂, NOF et éventuellement HF du fait de l'humidité résiduelle dans l'air de dilution. Après passage sur la cartouche 10 de neutralisation, aucun de ces polluants dangereux de l'air n'est présent dans le flux gazeux à une concentration supérieure à la valeur moyenne ou limite d'exposition.

Le taux d'abattement du C₄F₈ est quasiment de 100%, la concentration résiduelle étant inférieure au niveau de bruit de la détection. Les taux d'abattement de SF₆ sont donnés dans le tableau I pour différentes conditions. On observe bien que le taux d'abattement augmente avec la puissance micro-ondes incidente, c'est-à-dire avec l'extension de la zone de plasma. On constate également que l'efficacité de destruction, toutes choses égales par ailleurs, augmente lorsque le diamètre du tube diminue. En outre, le sens de passage du flux gazeux, montant ou descendant, affecte peu l'efficacité de destruction, mais permet d'éviter certains risques déjà exposés ci-dessus.

Des résultats similaires sont obtenus à des débits plus élevés de SF₆ (jusqu'à 300 sccm) et de plus fortes dilutions (jusqu'à 70 slm), et pour d'autres PFC comme C₃F₈, NF₃, C₂F₆, CF₄, CHF₃...

Dans le tableau I, l'»entrée procédé » désigne l'entrée du réacteur 2, et l' »entrée détox » désigne l'entrée du dispositif de traitement 8.

**Tableau I**

| | | | **Gaz dilution** | | **Adjuvant O₂ (slm)** | **Taux de destruction** | | | |
|---|---|---|---|---|---|---|---|---|---|
| **Ø tube (mm)** | **Débit SF₆ entrée procédé (slm)** | **Débit SF₆ entrée détox (slm)** | **Air (slm)** | **N₂ (slm)** | | **Pₘᵢₙ (kW)** | **%** | **Pₘₐₓ (kW)** | **%** |
| 10⁽¹⁾ | - | 170 | - | 20 | 1 | 3 | 70 | 3 | 70 |
| | 170 | 75 | 30 | - | - | 3 | 70 | 3 | 70 |
| 8⁽¹⁾ | - | 170 | - | 20 | 1 | 3 | 97 | 3,5 | 98 |
| | 170 | 75 | 30 | - | | 2,5 | 94 | 3,5 | 97 |
| 6⁽¹⁾ | - | 170 | - | 20 | 1 | 1,6 | 95 | 2,5 | 99 |
| 10⁽²⁾ | - | 300 | 30 | - | 0,45 | 3,5 | 77 | 3,5 | 77 |
| 8⁽³⁾ | - | 200 | 20 | - | 0,3 | 3,5 | 97 | 3,5 | 97 |
| 10⁽³⁾ | - | 200 | 20 | - | 0,3 | 3,5 | 81 | 3,5 | 81 |
| 12⁽²⁾ | - | 200 | 20 | - | 0,3 | 3,5 | 67 | 3,5 | 67 |
| (1) Mesure sur alpha-test avec procédé gravure en arret / marche | | | | | | | | | |
| (2) Mesure laboratoire flux montant | | | | | | | | | |
| (3) Mesure laboratoire flux descendant | | | | | | | | | |

L'invention a été décrite dans le cadre d'un chambre 2 de production ou de gravure d'éléments semi-conducteurs.

Elle s'applique de la même manière, et avec les mêmes avantages au cas d'une chambre ou d'un réacteur 2 de production ou de croissance ou de gravure ou de nettoyage ou de traitement de semiconducteurs ou de dispositifs semiconducteurs ou de couches minces ou de couches minces semiconductrices ou conductrices ou diélectriques ou de substrats, par exemple de substrats en silicium lors de la fabrication de micro-composants ou de micro-optiques.

Elle s'applique aussi, là encore avec les mêmes avantages que décrits ci-dessus, dans le cas d'un réacteur de retrait de résines photosensibles utilisées pour la lithographie des micro-circuits, ou bien dans le cas d'un réacteur de dépôt de couches minces en cours de nettoyage par plasma.

## Revendications

1. Système de traitement de gaz par plasma, comportant :
- un moyen (6) de pompage, dont la sortie est à une pression sensiblement égale à la pression atmosphérique,
- des moyens (8), en sortie de pompe, pour produire un plasma hors d'équilibre thermodynamique local à pression atmosphérique, la source plasma étant du type entretenu par un champ de hautes fréquences supérieur à 50 MHz, lesdits moyens comportant une enceinte généralement tubulaire (26) où est entretenu le plasma, le gaz traversant ce tube de haut en bas.

2. Système de traitement selon la revendication 1, **caractérisée en ce qu'**il comporte des moyens de refroidissement disposés en aval du tube (26).

3. Système selon l'une des revendications 1 à 2, **caractérisé en ce qu'**il comporte des moyens de vidange en position basse du tube.

4. Système selon les revendications 2 et 3, **caractérisé en ce qu'**il comporte une structure d'échangeur collecteur.

5. Système selon l'une des revendications 1 à 4, **caractérisé en ce qu'**il comporte un dispositif (10) de post traitement des sous-produits.

6. Système selon l'une des revendications précédentes, les moyens (8) pour produire un plasma permettant de produire un plasma ayant une densité électronique au moins égale à 10¹² cm-³, ou comprise entre 10¹² cm⁻³ et 10¹⁵ cm⁻³ ou comprise entre 10¹³ cm⁻³ et 10¹⁴ cm⁻³

7. Système selon l'une des revendications précédentes, les moyens (8) pour produire un plasma comportant un tube de longueur comprise entre 100 mm et 400 mm.

8. Système selon l'une des revendications précédentes, les moyens (8) pour produire un plasma comportant un tube de diamètre interne compris entre 8 mm et 4 mm.

9. Système selon l'une des revendications précédentes, les moyens (8) pour produire un plasma comportant des moyens pour générer un vortex dans la décharge de façon à rendre curviligne plutôt que linéaire la trajectoire des particules.

10. Système selon l'une des revendications 1 à 10, **caractérisé en ce qu'**il comporte un système de vannes de dérivation en sortie de pompe permettant l'évitement du système de traitement par le flux gazeux.

11. Procédé de traitement de gaz par plasma notamment de traitement d'effluents de fabrication de semi-conducteurs, dans lequel on prélève les gaz à traiter à la sortie d'une pompe, à une pression, sensiblement égale à la pression atmosphérique, **caractérisée en ce que** l'on introduit lesdits gaz à traiter dans une enceinte généralement tubulaire où est entretenu un plasma hors d'équilibre thermodynamique local, ledit plasma étant entretenu par un champ de hautes fréquences supérieures à 50 MHz, le gaz traversant le plasma de haut en bas.

12. Procédé selon la revendication 11 **caractérisé en ce que** la densité électronique du plasma est au moins égale à 10¹²cm⁻³ de préférence comprise entre 10¹² et 10¹⁵ cm⁻³, plus préférentiellement comprise entre 10¹³ et 10¹⁴cm⁻³.

13. Procédé selon l'une des revendications 11 et 12, **caractérisé en ce que** les gaz sont refroidis après traitement par le plasma.

14. Procédé selon l'une des revendications 11 à 13, **caractérisé en ce qu'**il est prévu un système de post traitement (10) des sous produits.

15. Procédé selon l'une des revendications 11 à 14, **caractérisé en ce que** l'on génère un vortex dans la décharge du plasma de façon à rendre curviligne plutôt que linéaire la trajectoire des particules.

## Claims

1. System for the plasma treatment of gases, comprising:
- a pumping means (6), the outlet of which is at a pressure substantially equal to atmospheric pressure; and
- means (8), downstream of the pump, for producing a plasma not in local thermodynamic equilibrium at atmospheric pressure, the plasma source being of the type sustained by a high-frequency field, at a frequency above 50 MHz, said means including a generally tubular chamber (26) where the plasma is sustained, the gas passing through this tube from the top down.

2. Treatment system according to Claim 1, **characterized in that** it includes cooling means placed downstream of the tube (26).

3. System according to either of Claims 1 and 2, **characterized in that** it includes draining means in the bottom position of the tube.

4. System according to Claims 2 and 3, **characterized in that** it includes a collector exchanger structure.

5. System according to one of Claims 1 to 4, **characterized in that** it includes a device (10) for the post-treatment of the by-products.

6. System according to one of the preceding claims, the means (8) for producing a plasma making it possible to generate a plasma having an electron density of at least 10¹² cm⁻³, or between 10¹² cm⁻³ and 10¹⁵ cm⁻³ or between 10¹³ cm⁻³ and 10¹⁴ cm⁻³.

7. System according to one of the preceding claims, the means (8) for producing a plasma comprising a tube of length between 100 mm and 400 mm.

8. System according to one of the preceding claims, the means (8) for producing a plasma comprising a tube with an inside diameter of between 8 mm and 4 mm.

9. System according to one of the preceding claims, the means (8) for producing a plasma comprising means for generating a vortex in the discharge so as to make the path of the particles curvilinear rather than linear.

10. System according to one of Claims 1 to 9, **characterized in that** it includes a system of bypass valves downstream of the pump, making it possible to avoid the gas flow treatment system.

11. Method for the plasma treatment of gases, especially for the treatment of semiconductor fabrication effluents, in which the gases to be treated are taken at the outlet of a pump, at a pressure substantially equal to atmospheric pressure, **characterized in that** said gases to be treated are introduced into a generally tubular chamber where a plasma not in local thermodynamic equilibrium is sustained, said plasma being sustained by a high-frequency field at a frequency of greater than 50 MHz, the gas passing through the plasma from the top down.

12. Method according to Claim 11, **characterized in that** the electron density of the plasma is at least equal to 10¹² cm⁻³, preferably between 10¹² and 10¹⁵ cm⁻³ and more preferably between 10¹³ and 10¹⁴ cm⁻³.

13. Method according to either of Claims 11 and 12, **characterized in that** the gases are cooled after the plasma treatment.

14. Method according to one of Claims 11 to 13, **characterized in that** a system (10) for the post-treatment of the by-products is provided.

15. Method according to one of Claims 11 to 14, **characterized in that** a vortex is generated in the plasma discharge so as to make the path of the particles curvilinear rather than linear.

## Patentansprüche

1. System zur Behandlung von Gas durch Plasma, umfassend:
- ein Pumpmittel (6), dessen Ausgang einen Druck aufweist, der im Wesentlichen gleich dem Luftdruck ist,
- Mittel (8) am Ausgang der Pumpe, um ein Plasma zu produzieren, das bei Luftdruck aus dem lokalen thermodynamischen Gleichgewicht ist, wobei die Plasmaquelle dem Typus entspricht, der durch ein Hochfrequenzfeld oberhalb von 50 MHz aufrechterhalten wird, wobei besagte Mittel eine im Allgemeinen röhrenförmige Ummantelung (26), in der das Plasma gehalten wird, umfassen, und das Gas diese Röhre von oben nach unten durchströmt.

2. Behandlungssystem nach Anspruch 1, **dadurch gekennzeichnet, dass** es Kühlmittel umfasst, die sich abwärts des Rohres (26) befinden.

3. System nach einem der Ansprüche 1 bis 2, **dadurch gekennzeichnet, dass** es Abflussmittel umfasst, die sich unten im Rohr befinden.

4. System nach den Ansprüchen 2 und 3, **dadurch gekennzeichnet, dass** es eine Austausch-Abscheidungs-Struktur umfasst.

5. System nach einem der Ansprüche 1 bis 4, **dadurch gekennzeichnet, dass** es eine Vorrichtung (10) zur Nachbehandlung der Nebenprodukte umfasst.

6. System nach einem der vorangegangenen Ansprüche, wobei die Mittel (8) zur Herstellung eines Plasmas die Herstellung eines Plasmas mit einer elektronischen Dichte von mindestens gleich 10¹² cm⁻³ gestatten oder zwischen 10¹² cm⁻³ und 10¹⁵ cm⁻³ oder zwischen 10¹³ cm⁻³ und 10¹⁴ cm⁻³.

7. System nach einem der vorangegangenen Ansprüche, wobei die Mittel (8) zur Herstellung eines Plasmas ein Rohr mit einer Länge von zwischen 100 mm und 400 mm umfassen.

8. System nach einem der vorangegangenen Ansprüche, wobei die Mittel (8) zur Herstellung eines Plasmas ein Rohr mit einem inneren Durchmesser von zwischen 8 mm und 4 mm umfassen.

9. System nach einem der vorangegangenen Ansprüche, wobei die Mittel (8) zur Herstellung eines Plasmas Mittel zur Erzeugung eines Wirbels in der Entladung umfassen, so dass der Durchlauf der Partikel mehr krummlinig wird als linear.

10. System nach einem der Ansprüche 1 bis 10, **dadurch gekennzeichnet, dass** es ein System mit Ablaufventilen am Ausgang der Pumpe umfasst, wodurch der Gasstrom das Behandlungssystem umgehen kann.

11. Verfahren zur Behandlung von Gas durch Plasma, insbesondere zur Behandlung von Abgasen, die bei der Herstellung von Halbleitern entstehen, bei dem man die zu behandelnden Gase am Ausgang einer Pumpe und bei einem Druck entnimmt, der dem Luftdruck im Wesentlichen gleich ist, **dadurch gekennzeichnet, dass** man besagte zu behandelnde Gase in eine im Allgemeinen röhrenförmige Ummantelung einführt, wo ein Plasma gehalten wird, das aus dem lokalen thermodynamischen Gleichgewicht ist, wobei besagtes Plasma durch ein Hochfrequenzfeld oberhalb von 50 MHz aufrechterhalten wird und das Gas das Plasma von oben nach unten durchströmt.

12. Verfahren nach Anspruch 11, **dadurch gekennzeichnet, dass** die elektronische Dichte des Plasmas mindestens gleich 10¹² cm⁻³, vorzugsweise zwischen 10¹² und 10¹⁵ cm⁻³ und insbesondere zwischen 10¹³ und 10¹⁴ cm⁻³ ist.

13. Verfahren nach einem der Ansprüche 11 und 12, **dadurch gekennzeichnet, dass** die Gase nach der Behandlung durch das Plasma abgekühlt werden.

14. Verfahren nach einem der Ansprüche 11 bis 13, **dadurch gekennzeichnet, dass** ein System zur Nachbehandlung (10) der Nebenprodukte vorgesehen ist.

15. Verfahren nach einem der Ansprüche 11 bis 14, **dadurch gekennzeichnet, dass** man in der PlasmaEntladung einen Wirbel erzeugt, so dass der Durchlauf der Partikel eher krummlinig als linear verläuft.
